# EUROPÄISCHE PATENTSCHRIFT

(11) **EP 0 456 858 B1**
(45) Veröffentlichungstag und Bekanntmachung des Hinweises auf die Patenterteilung: **15.09.1993**
(21) Anmeldenummer: 90109256.9
(22) Anmeldetag: 16.05.1990
(51) Int. Cl.: H01R 13/17, H01R 13/658, H05K 9/00

(54) **Erdungsvorrichtung**
Earthing device
Dispositif de mise à la terre

(43) Veröffentlichungstag der Anmeldung: 21.11.1991
(73) Patentinhaber: SIEMENS AKTIENGESELLSCHAFT, 80333 München (DE)
(72) Erfinder: Seidel, Peter, D-8038 Gröbenzell (DE); Zell, Karl, D-8130 Niederpöcking (DE)

(56) Entgegenhaltungen:
- EP-A- 0 203 404
- DE-U- 8 911 590
- FR-A- 879 445

## Beschreibung

Die Erfindung betrifft eine Erdungsvorrichtung zur elektrischen Verbindung von Abschirmungen mehrpoliger Stecker mit der Erdpotentialschicht einer mehrere, senkrecht auf ihr stehende Kontaktmesser enthaltenden Verdrahtungsplatte.

Dabei weisen derartige Erdungsvorrichtungen Federelemente auf, die in Verbindung mit den Abschirmungen so angeordnet sind, daß sie im gesteckten Zustand der Stecker federnd an mit der Erdpotentialschicht der Verdrahtungsplatte leitend verbundenen Kontaktmesser anliegen.

Eine derartige Erdungsvorrichtung ist z. B. aus der europäischen Patentanmeldung EP 0 203 404 A2 bekannt. Ein Nachteil dieser bekannten Erdungsvorrichtungen ist, daß sie einen erheblichen Herstellungsaufwand erfordern und von Anfang an vorgesehen sein müssen, d. h. sie können nicht im Bedarfsfalle nachgerüstet werden. Ein weiterer Nachteil der bekannten Vorrichtungen ist, daß nicht immer ein optimaler Stromfluß zur Erdpotentialschicht gegeben ist.

Eine Erdungsvorrichtung, dem Oberbegriff des Anspruchs 1 entsprechend, ist aus DE-U- 89 11 590.2 bekannt.

Aufgabe der vorliegenden Erfindung ist es, eine Erdungsvorrichtung der eingangs genannten Art anzugeben, welche einfach herzustellen ist und nachträglich angebracht werden kann.

Diese Aufgabe wird erfindungsgemäß für eine Erdungsvorrichtung der obengenannten Art dadurch gelöst, daß ein mit Querschlitzen versehener, um seine Längsachse gebogener Stanzstreifen zwei Randbereiche aufweist, wobei jeweils zwischen der Längsachse und einem der Randbereiche nach außen gewölbte, parallel zu den Querschlitzen verlaufend Federbereiche angeordnet sind, wobei in vorgegebenen Abständen voneinander im ersten Randbereich Stege mit Ausnehmungen und mit diesen fluchtend im zweiten Randbereich Durchbrüche vorgesehen sind, und wobei die äußeren Randbereiche zueinander abgeknickt sind, daß der Stanzstreifen im Einbauzustand soweit zusammengedrückt ist, daß die Stege des ersten Randbereichs die Durchbrüche des zweiten Randbereichs derart durchgreifen, daß jeweils die Ausnehmungen zusammen mit den Durchbrüchen Aufnahmeöffnungen für die Kontaktmesser bilden.

Die erfindungsgemäße Erdungsvorrichtung ist leicht herzustellen und läßt sich auch leicht nachträglich installieren, um Abschirmungen bzw. Schirmbleche über Kontaktmesser mit der Erdpotentialschicht zu verbinden. Aufgrund der durchlaufenden Randbereiche in unmittelbarer Nachbarschaft zur Verdrahtungsplatte, auf welcher sich die Erdpotentialschicht befindet, ergibt sich im Bedarfsfalle ein optimaler Stromfluß.

Eine zweckmäßige Weiterbildung der erfindungsgemäßen Erdungsvorrichtung ist dadurch gekennzeichnet, daß im zweiten Randbereich jeweils zwischen zwei Durchbrüchen einseitig von einem Halbkreis begrenzte Lochungen angeordnet sind. Diese Lochungen wirken als Kralle und verhindern beim Ziehen der abgeschirmten Stecker ein versehentliches Mitabziehen der Erdungsvorrichtungen.

Im folgenden wird die Erfindung anhand eines in der Zeichnung dargestellten Ausführungsbeispiels näher erläutert. Es zeigen
- FIG 1: einen Schnitt durch eine Erdungsvorrichtung gemäß der vorliegenden Erfindung,
- FIG 2: eine Seitenansicht des dargestellten Ausführungsbeispiels,
- FIG 3: eine Abwicklung des zur Herstellung des in FIG 1 und FIG 2 gezeigten Ausführungsbeispiels benötigten Stanzstreifen, und
- FIG 4: ein Anwendungsbeispiel der erfindungsgemäßen Erdungsvorrichtung.

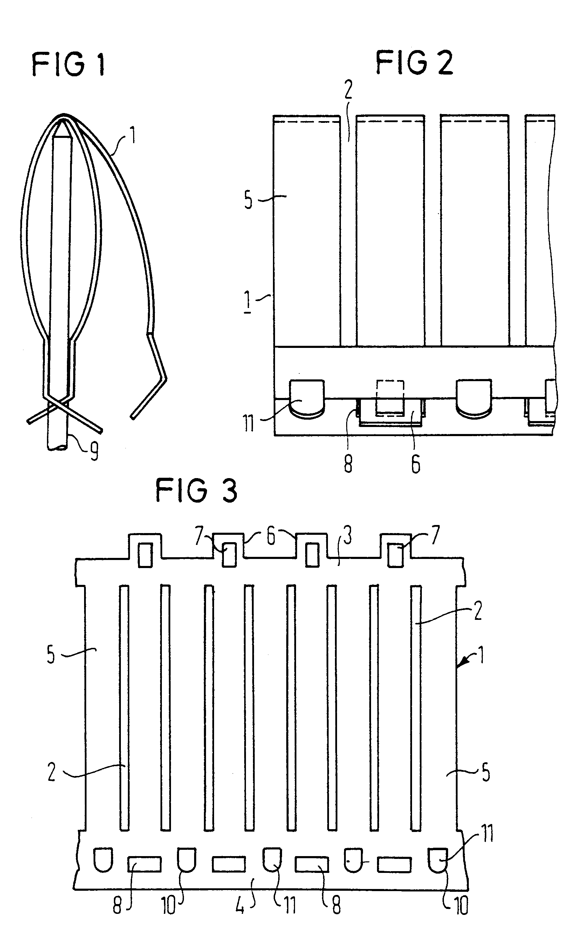

In FIG 3 ist als Ausgangsprodukt für die erfindungsgemäße Erdungsvorrichtung der Stanzstreifen 1 dargestellt. Dieser Stanzstreifen 1 weist zwischen Querschlitzen 2 jeweils gewölbte Federbereiche 5 beiderseits der Längsachse auf. Diese Wölbungen der Federbereiche 5 sind so ausgeführt, daß sie im vorgebogenen Zustand des Stanzstreifens 1 nach außen weisen, wie aus FIG 1 zu entnehmen ist. Seitlich ist der Stanzstreifen 1 von einem ersten Randbereich 3 und einem zweiten Randbereich 4 begrenzt.

Im ersten Randbereich 3 sind in vorgegebenen Abständen Stege 6 angeordnet. Innerhalb dieser Stege sind Ausnehmungen 7 vorgesehen, die teilweise in den Randbereich übergreifen. Fluchtend mit diesen Stegen sind im gegenüberliegenden zweiten Randbereich 4 sich in Längsrichtung erstreckende Durchbrüche 8 vorgesehen. Die äußeren Randbereiche sind um die in FIG 3 dargestellten Linien abgeknickt, und zwar derart, daß sie im abgebogenen Zustand des Stanzstreifens 1 zueinanderweisen, wie sich aus der Schnittzeichnung in FIG 1 ergibt.

Vor dem Einbau wird der Stanzstreifen 1 soweit vorgebogen, wie in FIG 1 dargestellt. Auf diese Weise wird für die Erreichung des Endzustandes eine gewisse Vorspannung erzeugt. Zur Erreichung des Endzustandes bzw. des Einbauzustandes werden die äußeren Randbereiche des Stanzstreifens soweit zusammengedrückt, daß die Stege 6 des ersten Randbereiches 3 durch die Durchbrüche 8 des zweiten Randbereichs 4 durchgesteckt werden. Sind die Stege 6 durch die Durchbrüche 8 durchgesteckt, so bilden die Ausnehmungen 7 der Stege 6 zusammen mit den Durchbrüchen 8 Aufnahmeöffnungen für die Kontaktmesser 9, so daß die Erdungsvorrichtung auf die Kontaktmesser 9 aufgeschoben werden kann, und aufgrund der Vorspannung auf diesen Kontaktmessern 9 gehalten wird.

Das Durchgreifen der Stege 6 durch die Durchbrüche 8 ergibt sich aus der Darstellung in FIG 2. Aufgrund der konstruktiven Gegebenheit der erfindungsgemäßen Erdungsvorrichtung kann diese in beliebiger Länge verwendet werden.

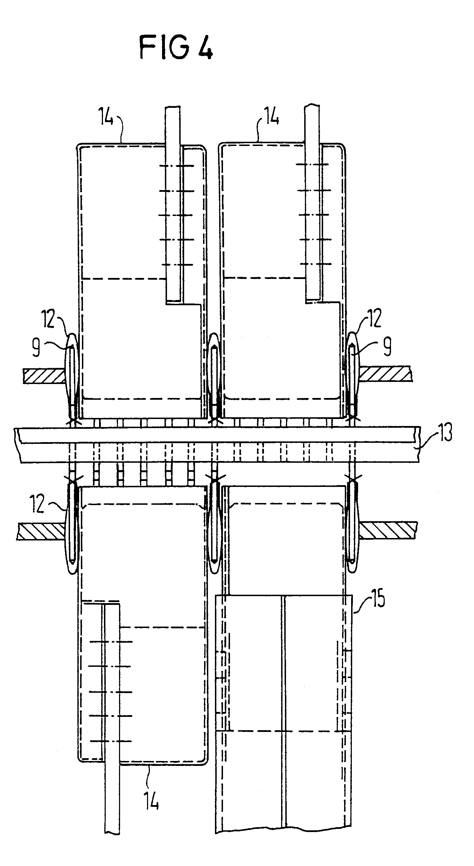

Ein Anwendungsbeispiel für die erfindungsgemäße Erdungsvorrichtung ist in FIG 4 dargestellt. Auf die mit Kontaktmessern 9 versehene Rückwandverdrahtung 13 sind Stecker 14 und 15 aufgesteckt. Bei diesen Steckern handelt es sich um abgeschirmte Stecker, die von Schirmblechen umgeben sind. Seitlich der Stecker sind Kontaktmesser 9 mit der erfindungsgemäßen Erdungsvorrichtung 12 versehen, über welche die Schirmbleche mit der Erdpotentialschicht verbunden sind. Aufgrund der durchgehenden Randbereiche der erfindungsgemäßen Erdungsvorrichtung ergibt sich im Bedarfsfalle ein optimaler Stromabfluß, da die Randbereiche sehr nahe parallel zur Erdpotentialschicht verlaufen.

Zwischen den Durchbrüchen 8 im zweiten Randbereich 4 sind einseitig von einem Halbkreis 10 begrenzte Lochungen 11 angeordnet, durch welche im Einbauzustand jedes zweite Kontaktmesser hindurchragt. Diese Lochungen 11 wirken als Kralle und verhindern beim Ziehen der Stecker ein versehentliches Mitabziehen der Erdungsvorrichtung.

## Patentansprüche

1. Erdungsvorrichtung zur elektrischen Verbindung von Abschirmungen mehrpoliger Stecker mit der Erdpotentialschicht einer mehrere, senkrecht auf ihr stehende Kontaktmesser enthaltenden Verdrahtungsplatte, wobei
ein mit Querschlitzen (2) versehener, um seine Längsachse gebogener Stanzstreifen (1) zwei Randbereiche (3, 4) aufweist, und wobei jeweils zwischen der Längsachse und einem der Randbereiche nach außen gewölbte, parallel zu den Querschlitzen (2) verlaufende Federbereiche (5) angeordnet sind, dadurch gekennzeichnet, daß in vorgegebenen Abständen voneinander im ersten Randbereich (3) Stege (6) mit Ausnehmungen (7) und mit diesen fluchtend im zweiten Randbereich (4) Durchbrüche (8) vorgesehen sind, und wobei die äußeren Randbereiche zueinanderweisend abgeknickt sind, daß der Stanzstreifen (1) im Einbauzustand soweit zusammengedrückt ist, daß die Stege (6) des ersten Randbereichs (3) die Durchbrüche (8) des zweiten Randbereichs (4) derart durchgreifen, daß jeweils die Ausnehmungen (7) zusammen mit den Durchbrüchen (8) Aufnahmeöffnungen für die Kontaktmesser (9) bilden.

2. Erdungsvorrichtung nach Anspruch 1,
**dadurch gekennzeichnet,**
daß im zweiten Randbereich (4) jeweils zwischen zwei Durchbrüchen (8) einseitig von einem Halbkreis (10) begrenzte Lochungen (11) angeordnet sind.

## Claims

1. Earthing device for the electrical connection of screens of multipole plugs to the earth-potential layer of a wiring board which contains a plurality of contact blades which are positioned vertically on it, a stamped strip (1), which is provided with lateral slots (2) and is bent about its longitudinal axis, having two edge regions (3, 4), and outwardly domed spring regions (5), which run parallel to the lateral slots (2), being arranged in each case between the longitudinal axis and one of the edge regions, characterised in that webs (6) having recesses (7) are provided at predetermined distances from one another in the first edge region (3) and perforations (8) are provided, aligned therewith, in the second edge region (4), and the outer edge regions being bent such that they point towards one another, in that the stamped strip (1) is compressed in the installed state so far that the webs (6) of the first edge region (3) pass through the perforations (8) in the second edge region (4) in such a manner that the recesses (7), together with the perforations (8), in each case form retaining openings for the contact blades (9).

2. Earthing device according to Claim 1, characterised in that holes (11), which are bounded on one side by a semicircle (10), are in each case arranged between two perforations (8) in the second edge region (4).

## Revendications

1. Dispositif de mise à la terre pour la liaison électrique de blindages de connecteurs multipolaires à la couche de potentiel de terre d'une plaque de câblage contenant plusieurs couteaux de contact perpendiculaires à cette plaque, du type dans lequel une bande découpée (1), qui comporte des fentes transversales (2) et qui est repliée autour de son axe longitudinal, comporte deux zones marginales (3, 4), et dans lequel, respectivement entre l'axe longitudinal et l'une des zones marginales, sont aménagées des parties élastiques (5) qui sont cintrées vers l'extérieur et qui sont parallèles aux fentes transversales (2), caractérisé par le fait que, dans la première zone marginale (3), il est prévu, à des intervalles prédéterminés, des barrettes (6) comportant des ouvertures (7), et que dans la seconde zone marginale (4), il est prévu des passages (8) alignés avec ces ouvertures, les zones marginales extérieures étant repliées les unes vers les autres, et qu'à l'état monté, la bande découpée (1) est comprimée de sorte que les barrettes (6) de la première zone marginale (3) traversent les passages (8) de la seconde zone marginale (4) de telle manière que respectivement les ouvertures (16) forment, avec les passages (8), des ouvertures de logement pour les couteaux de contact (9).

2. Dispositif de raccordement à la terre suivant la revendication 1, caractérisé par le fait que, dans la seconde zone marginale (4), des trous (11) limités unilatéralement par un demi-cercle (10) sont aménagés respectivement entre deux passages (8).
